# EUROPEAN PATENT APPLICATION

(11) **EP 1 463 276 A1**
(43) Date of publication of application: **29.09.2004**
(21) Application number: 04251524.7
(22) Date of filing: 17.03.2004
(51) Int. Cl.: H04M 1/24, G01R 1/04

(54) **Electronic test & diagnostic apparatus**

(30) Priority: 18.03.2003 GB 0306170
(71) Applicant: Staffordshire University, Stoke on Trent, Staffordshire ST4 2XN (GB)
(72) Inventor: Heath, Mark, Staffordshire ST13 8AY (GB)
(74) Representative: Gray, James

(57) **Abstract**

The present invention discloses a test apparatus (10,20) for an electronic device having an interface adapted to receive a removable data carrying member. The test apparatus (10, 20) comprises an interface member (12) adapted to fit to said removable data carrying member interface and a display (18) operable to display information supplied to the interface during operation of the electronic device. The test apparatus (10,12) is powered by the power source of the electronic device.

## Description

The present invention relates to an electronic test and diagnostic apparatus and in particular to an electronic test and diagnosis apparatus adapted to interface with devices which interact with removable data carrying members. Such removable data carrying members may conform to those specified and regulated under ISO 7816, contact interface smart media and contactless radio frequency smart media conforming to ISO 14443, ISO 15693 and 124 kHz.

It is known for certain types of electronic device to utilise removable data carrying members which carry information about a particular user of the devices. The device may, for example be a mobile telephony device having a removable subscriber information module (sim) card, or an automated bank teller device adapted to receive a bank card of the chip card type. Both sim cards and chip cards comprise thin substrate in which is embedded a data carrying means. Provided on the surface of the substrate is a contact pad which, in use, rests against an interface means of the electronic device. Typically the contact pad comprises an expanse of metal foil and the interface means an array of sprung metal fingers.

With the increasing complexity of, for example, mobile phones, the diagnosis of hardware and software faults typically requires the service of a skilled engineer. Where a fault develops with a mobile phone it may require to be sent for testing thereby depriving the user of the phone for a period of time.

According to the present invention the is provided a test apparatus for an electronic device having an interface adapted to receive a removable data carrying member, the test apparatus comprising an interface member adapted to fit to said removable data carrying member interface and a display, the display being operable to display information supplied to the interface during operation of the electronic device, wherein the test apparatus is powered by the power source of the electronic device.

The present invention provides an apparatus which can indicate the operation or otherwise of the electronic device by providing indications on the display which correspond to signals sent by the electronic device to its removable data carrying member interface. The apparatus may advantageously be used to visualise via the display the internal start up operations and sequences of the electronic device when it is switched on.

In a simple form, the display may comprises a plurality of LED's which are illuminated in response to information being supplied to the interface. Alternatively the display may comprise an LCD screen. By observing the illumination sequence of the LED's a user is provided with an indication as to the operation of the electronic device. The failure of one or more LED's to illuminate, or the out of sequence illumination of the LED's, may indicate to the user that the electronic device is faulty and further may assist in identifying where a fault may lie.

The interface member preferably corresponds in size and shape to the removable data carrying member. The interface member may comprise a rigid, relatively thin base having a plurality of electrically conductive portions or pads supported thereon. In such an embodiment each portion or pad may be connected to a separate portion of the output. For example, each portion or pad may be connected to a separate LED.

The information supplied to the interface by the electronic device typically comprise one ore more voltages. The voltages may supplied in any of a number of forms, for example the voltages may be constant, intermittent, vary over time or any combination of the foregoing. The output is configured to readily display the condition of the voltages.

In an alternative embodiment the interface member may be spaced from the display by an electrically conductive connector. Preferably the connector is flexible. The display may be incorporated in to a housing. The housing may include an interface adapted to receive a removable data carrying member of the type fittable to the electronic device being tested. The housing may further include an interface adapted to enable information to be supplied to the device being tested through the module, flexible connector and interface means.

According to a further aspect of the present invention there is provided a method of testing an electronic device having an interface adapted to receive a removable data carrying member, the method comprising the steps of:
providing a test apparatus having an interface member fittable to a removable data
carrying member interface of an electronic device and a display;
placing said interface into contact with the removable data carrying member interface;
operating the electronic device; and
viewing via the output information supplied to the interface by the electronic device.

In a preferred embodiment the test apparatus is fitted to the electronic device before the electronic device is switched on in order that the test apparatus is able to provide an indication of the start up operations of the electronic device.

Embodiments of the present invention will now be described with reference to the accompanying drawings in which:
Figure 1 shows a diagrammatic representation of a first embodiment of an electronic test and diagnosis apparatus according to the present invention; and
Figure 2 shows a diagrammatic representation of a second embodiment of an electronic test and diagnosis apparatus according to the present invention.

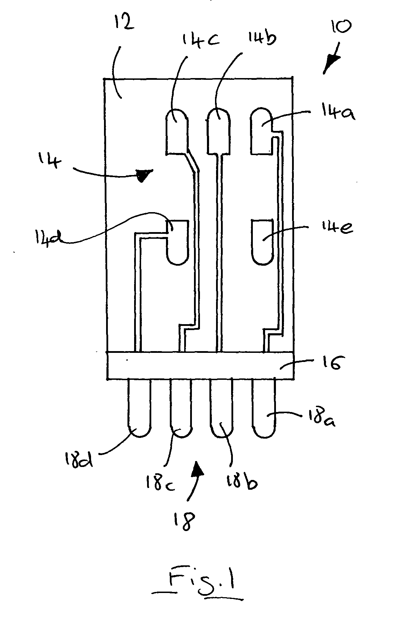

Referring firstly to figure 1 there is shown an electronic test and diagnosis apparatus generally designated 10 adapted for use with a mobile telephone. The apparatus 10 comprises a base 12 having a number of contact pads 14 supported thereon. It will be appreciated that the contact pads 14 are arranged in configuration mirroring those of a sim card. The base 12 is rigid and manufactured from a material which is electrically insualtive, for example a resin impregnated glass fibre substrate having a thickness of between 0.5 mm to 1 mm. The contact pads 14 comprise thin metallic films attached to the base 12. The films may be provided on the base 12 by known methods such as, for example, etching, vapour deposition or sputtering.

The contact pads 14 are electrically connected through a resistance means 16 to a plurality of indicators 18. In the embodiment shown the resistance means is represented by a block 20 provided intermediate the base 12 and the indicators 18. The indicators comprise four light emitting diodes (LED's) each of which is associated with a particular contact pad 14. It will be apparent to a person skilled in this particular art the required value and arrangement of resistors in the resistance means 16 to enable the LED's to operate in the manner to be described below.

In the embodiment shown, there are provided five contact pads 14. The pads 14 are arranged such that their positions match those of certain fingers of the mobile telephone interface means. The fingers of the interface means, in turn, are connected to various internal data lines of the mobile telephone. The provision of such data lines and the position of their corresponding finger on the interface means are governed by international standard, namely ISO 7816. Thus in the embodiment shown pad 14a corresponds to the voltage or VCC line, pad 14b to the Reset line, pad 14c to the Clock line, pad 14d to the I/O or Data line, and pad 14e to the Ground line. Similarly, LED 18a corresponds to the VCC line, LED 18b to the Reset line, LED 18c to the Clock line, and LED 18d to the Data line.

As described above, a sim card, when inserted into a mobile telephone, contacts an interface means. In a corresponding manner, the apparatus 10, when inserted into the sim card holder of a mobile telephone, contacts the interface means in an electrically conductive manner. When a mobile telephone is switched on, there exists a predefined sequence whereby power is supplied to the various internal data lines. In accordance with ISO 7816 there exists a standardised power up sequence whereby the telephone interrogates the sim card socket to ascertain whether or not a sim card is fitted thereto. The sequence comprises the sending of three pulses of 3 volts, followed by three pulses of 5 volts. This should result in corresponding flashes of the LED's. A fault will result in one or more of the LED's failing to illuminate.

The present invention allows this power up sequence to be observed via the LED's and thereby indicate to an informed user of the apparatus 10 the internal state of the mobile telephone. By observing any deviation from the predefined sequence, the user's attention may be directed to a problem with a particular data line or lines. This in turn may indicate whether a particular internal component of the mobile telephone is faulty and lead the user to make an informed decision as to whether or not the telephone is beyond economic repair. It will thus be appreciated that the device of the present invention enables repair personnel to correctly identify the failing data lines within the mobile telephone and aid in the correct diagnosis of a fault. This ability reduces diagnostic time at a repair site or during a manufacture production run. It will further be appreciated that the present invention does not require an internal power source as it relies on the power source of the mobile telephone.

The predetermined sequence whereby power is supplied to the interface by the telephone on start up is carried out irrespective of whether or not a sim card is fitted to the telephone. This power up sequence is also carried out irrespective of whether there exist any sim lock settings or any other security feature of the telephone enabled.

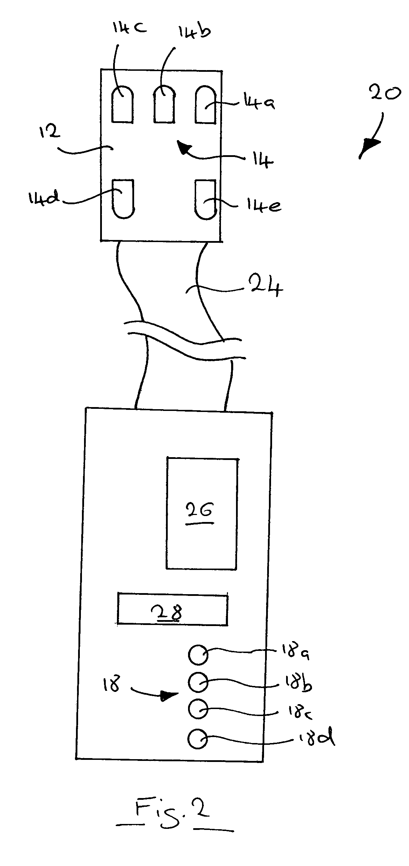

Referring now to Figure 2 there is shown an alternative embodiment of an electronic test and diagnosis apparatus according to the present invention generally designated 20. Features common to the apparatus of figure 1 are identified with like reference numerals. The apparatus 20 differs in that the base 12 and contact pads 14 are separated from a module 22 housing the indicators 18 and resistance means by a flexible tape connector 24. The tape connector 24 advantageously allows the apparatus 20 to be connected to the sim socket of a mobile telephone without impeding the fitting and operation of the telephone battery pack. The flexible nature of the tape connector 24 allows it to lie under or around the battery pack while allowing communication to the module 22.

The module 22 embodies additional features over and above those of the first described embodiment of the apparatus 10. The module 22 further includes a sim card docking port 26. This docking port 26 can receive the sim card of a phone which has been removed in order that the base 12 and contact pads 14 can be fitted thereto. Once fitted to the docking port 26, the sim card is electrically connected to the phone by virtue of the tape connector 22 and the contact pads 14 of the base 12. The sim card thus, in effect, rides piggy back on the module, with the telephone believing that it is connected to the sim card in a normal manner. This allows a user to subsequently operate the telephone in a normal manner, for example by making and receiving calls, while at the same time observing via the LED's the electrical connections made between the telephone hardware and the sim card.

The module 22 further includes an interface 28 which enables a user to connect to the mobile telephone external instrumentation and diagnostic equipment, Such equipment may be used to monitor in greater detail the interaction between the internal componentry of the mobile telephone and the sim card. The equipment may further be operable to illustrate the real-time interaction between hardware and software of the mobile telephone including, for example, data transmission and wireless reception characteristics. The interface 28 may also via the connection of appropriate hardware thereto, be utilised to send information to the mobile telephone. Such information may be utilised for a number of operations such as, for example, reprogramming of hardware or software, or interrogation of system components.

The embodiments of the present invention have been described with reference to mobile telephone apparatus, however it will be appreciated that the present invention may be utilised in conjunction with a multitude of other technologies which utilise removable data carrying means corresponding, but not limited, to the ISO 7816 standard contact interface, smart media and contactless radio frequency smart media conforming to ISO 14443, ISO 15693 and 124 kHz.. Examples of such technologies include:
Transport: tickets, commuter passes and prepaid travel cards.
Distribution: tags for freight.
Identification: student and employee identity cards, citizen ID, driving licences, passports.
Financial & Payment function: cash cards, credit cards, debit cards, store cards, customer loyalty cards, prepaid phone cards.

## Claims

1. A test apparatus (10,20) for an electronic device having an interface adapted to receive a removable data carrying member, the test apparatus (10,20) comprising an interface member (12) adapted to fit to said removable data carrying member interface and a display (18), the display (18) being operable to display information supplied to the interface during operation of the electronic device, wherein the test apparatus (10,20) is powered by the power source of the electronic device.

2. A test apparatus (10,20) as claimed in claim 1 wherein the display (18) comprises one or more light emitting diodes (18a,18b,18c,18d) which are illuminated in response to information being supplied to the interface.

3. A test apparatus (10,20) as claimed in claim 2 wherein said one or more light emitting diodes (18a,18b,18c,18d) are illuminated in response to one or more voltages being supplied to the interface.

4. A test apparatus (10,20) as claimed in any preceding claim wherein the interface member (12) corresponds in size and shape to the removable data carrying member.

5. A test apparatus (10,20) as claimed in claim 4 wherein the interface member (12) comprises a rigid, relatively thin base having a plurality of electrically conductive pads (14) supported thereon.

6. A test apparatus (10,20) as claimed in claim 5 wherein said conductive pads (14) are arranged in a pattern corresponding to that of conductive pads on a removable data carrying member.

7. A test apparatus (10,20) as claimed in any preceding claim wherein the interface member (12) is spaced from the display (18) by an electrically conductive connector (24).

8. A test apparatus (10,20) as claimed in any preceding claim wherein the apparatus (20) includes an interface (26) adapted to receive a removable data carrying member of the type fittable to tan electronic device being tested.

9. A test apparatus (10,20) as claimed in any preceding claim wherein the housing further includes an interface (28) to enable additional output means to be connected thereto.

10. A test apparatus (10,20) as claimed in claim 9 wherein the interface (28) is further adapted to enable information to be supplied to the device being tested through the test apparatus.

11. A method of testing an electronic device having an interface adapted to receive a removable data carrying member, the method comprising the steps of:
providing a test apparatus having an interface member fittable to a removable data carrying member interface of an electronic device and an output;
placing said interface into contact with the removable data carrying member interface;
operating the electronic device; and
viewing via the output information supplied to the interface by the electronic device.

12. A method as claimed in claim 11 wherein the test apparatus is fitted to the electronic device before the electronic device is switched on in order that the test apparatus is able to provide an indication of the start up operations of the electronic device.
